# EUROPÄISCHE PATENTSCHRIFT

(11) **EP 2 954 503 B1**
(45) Veröffentlichungstag und Bekanntmachung des Hinweises auf die Patenterteilung: **26.04.2017**
(21) Anmeldenummer: 13712173.7
(22) Anmeldetag: 13.03.2013
(51) Int. Cl.: G08B 25/14, H01H 50/08, H03K 17/00, H01H 1/00, H01H 9/16, H03K 17/18, H02J 13/00

(54) **SYSTEM MIT EINEM MELDEGERÄT UND EINER MELDEGERÄTAUSWERTEVORRICHTUNG**
SYSTEM WITH A SIGNALING DEVICE AND A REMOTE EVALUATION
SYSTÈME AVEC UN DISPOSITIF DE SIGNALISATION ET UNE ÉVALUATION ÉLOIGNÉ

(43) Veröffentlichungstag der Anmeldung: 16.12.2015
(73) Patentinhaber: Siemens Aktiengesellschaft, 80333 München (DE)
(72) Erfinder: BEYER, Stefan, 92263 Ebermannsdorf (DE); CARLS, Erhard, 92284 Poppenricht/Traßlberg (DE)
(86) Internationale Anmeldenummer: PCT/EP2013/055135
(87) Internationale Veröffentlichungsnummer: WO 2014/139561

(56) Entgegenhaltungen:
- EP-A1- 2 290 666
- DE-A1-102007 002 176
- US-A- 3 105 951

## Beschreibung

Die Erfindung betrifft System mit einem Meldegerät und einer dezentral zum Meldegerät angeordneten Meldegerätauswertevorrichtung sowie ein Verfahren zum Ermitteln eines Schaltzustandes eines Meldegerätes mit einem derartigen System.

Derartige Systeme werden insbesondere im Bereich der Automatisierungstechnik, insbesondere der industriellen Automatisierungstechnik, eingesetzt.

Ein Meldegerät ist insbesondere ein Taster (z.B. ein Ein-Taster) oder ein Schalter (z.B. ein Ein/Aus Schalter, ein Drehschalter, ein Not-Aus Schalter). Durch eine Betätigung des Meldegerätes wird eine Zustandsänderung am Meldegerät herbeigeführt. Diese Zustandsänderung kann mit einer mit dem Meldegerät elektrisch verbundene Meldegerätauswertevorrichtung erfasst werden, so dass diese hierauf entsprechend reagieren kann. Meldegeräte werden innerhalb der Automatisierungstechnik beispielsweise in einem Bedienpult einer Fertigungsstraße eingesetzt, so dass ein Anwender durch eine Betätigung einzelner Meldegeräte des Bedienpults entsprechende Signale ausgeben kann.

Ein bekanntes Meldegerät ist beispielsweise ein Not-Aus Schalter. Der Not-Aus Schalter, auch Not-Aus genannt, ist ein Schalter, welcher üblicherweise dazu vorgesehen ist bei einer Betätigung des Schalters eine Maschine oder eine Anlage im Gefahrenfall oder zur Abwendung einer Gefahr schnell in einen sicheren Zustand zu versetzen. Je nach Einsatzfeld werden hierbei verschiedene Strategien verfolgt. Im einfachsten Fall folgt einer Betätigung des Not-Aus Schalters eine Unterbrechung der Stromzufuhr der Gefahr verursachenden Anlage oder Maschine. Hierfür kann beispielsweise der Steuerstromkreis eines Schützes, über welches die Energiezufuhr der Gefahr verursachenden Maschine geführt wird, über das Meldegerät oder eine mit dem Meldegerät verbundene Meldegerätauswertevorrichtung geführt werden. Wird das Meldegerät betätigt, so unterbricht es den Steuerstromkreis des Schützes, so dass das Schütz hierauf seine Kontakte öffnet und die Energiezufuhr zur Maschine unterbunden wird.

DE 10 2007 002 176 A1 zeigt eine Erfassungseinrichtung zum Erfassen des Schaltzustands eines elektromagnetischen Schaltgeräts. Meldegeräte umfassen üblicherweise mindestens drei Komponenten. Einen Betätiger, ein Aufnahmemodul und ein Basiserfassungsmodul. Der Betätiger umfasst insbesondere ein Tastelement oder ein Schaltelement zur unmittelbaren Betätigung seitens eines Anwenders. Im zusammengebauten Zustand des Meldegerätes sind der Betätiger sowie das Basiserfassungsmodul mechanisch mit dem Aufnahmemodul verbunden.

Durch eine Betätigung des Betätigers wird ein Stößel des Meldegerätes ausgelenkt. Über die Auslenkung des Stößels wird üblicherweise unmittelbar eine mechanische Kraft auf ein mechanisches Kontaktelement des Basiserfassungsmoduls ausgeübt, so dass dieses eine Zustandsänderung herbeiführt (das Kontaktelement wird geöffnet bzw. geschlossen). Durch eine Überwachung der Schaltstellung des Kontaktelements des Basiserfassungsmoduls, z.B. durch eine dezentrale Auswertevorrichtung, kann ein Rückschluss auf den vorliegenden Schaltzustand des Meldegerätes gewonnen werden.

Werden sicherheitskritische Applikationen durch ein Automatisierungssystem realisiert, so liegen erhöhte Sicherheitsanforderungen hinsichtlich der Auswertung des Schaltzustandes des Meldegerätes vor. Hierbei muss insbesondere sichergestellt werden, dass bei einer Betätigung des Meldegerätes ein sicherer Zustand der sicherheitskritischen Applikation herbeigeführt wird.

Eine Aufgabe der vorliegenden Erfindung ist es ein verbessertes System zum sicheren Ermitteln eines Schaltzustandes eines Meldegeräts bereitzustellen.

Diese Aufgabe wird gelöst durch eine Vorrichtung gemäß Anspruch 1, d.h. durch ein System mit einem Meldegerät und einer dezentral zum Meldegerät angeordneten Meldegerätauswertevorrichtung, wobei das Meldegerät einen ersten und zweiten Sensor, einen ersten und zweiten beweglich gelagerten Stößel und eine Auswerteeinheit umfasst, wobei der erste Sensor berührungslos eine erste Position des ersten Stößels erfasst und der zweite Sensor berührungslos eine erste Position des zweiten Stößels erfasst, wobei die Meldegerätauswertevorrichtung einen ersten und zweiten Ausgang und einen ersten und zweiten Eingang umfasst und zum sicheren Erfassen des Schaltzustandes des Meldegerätes über den ersten Ausgang ein erstes dynamisches Signal und über den zweiten Ausgang ein zweites dynamisches Signal, welches unterschiedlich zum ersten dynamischen Signal ist, sendet, wobei die Meldegerätauswertevorrichtung mit dem Meldegerät derart verbunden ist, dass ein über den ersten Ausgang ausgegebenes erstes dynamisches Signal über das Meldegerät zum ersten Eingang geführt werden kann und ein über den zweiten Ausgang ausgegebenes zweites dynamisches Signal über das Meldegerät zum zweiten Eingang geführt werden kann, wobei die Auswerteeinheit das über das Meldegerät geführte erste dynamische Signal ändert, wenn die erste Position des ersten Stößels ermittelt wird, und das über das Meldegerät geführte zweite dynamische Signal ändert, wenn die erste Position des zweiten Stößels ermittelt wird, wobei die Meldegerätauswertevorrichtung derart ausgebildet ist, dass sie den ersten und zweiten Eingang überwacht und hieraus den Schaltzustand des Meldegerätes ermittelt, sowie durch ein Verfahren gemäß Anspruch 11, d.h. durch ein Verfahren zum sicheren Ermitteln eines Schaltzustandes eines Meldegerätes mit einem System nach einem der Ansprüche 1 bis 10, wobei die Meldegerätauswertevorrichtung über den ersten Ausgang ein erstes dynamisches Signal und über den zweiten Ausgang ein zweites dynamisches Signal, welches unterschiedlich zum ersten dynamischen Signal ist, sendet, wobei das Meldegerät über den ersten Sensor die vorliegende Position des ersten Stößels und über den zweiten Sensor die vorliegende Position des zweiten Stößels ermittelt und sofern der erste Stößel die erste Position aufweist und der zweite Stößel die zweite Position aufweist das über das Meldegerät geführte erste und zweite dynamische Signal ändert, wobei die Meldegerätauswertevorrichtung den ersten und zweiten Eingang überwacht und hieraus den Schaltzustand des Meldegerätes ermittelt.

Vorteilhafte Weiterbildungen der Erfindung sind in den abhängigen Ansprüchen 2 bis 10 und 12 angegeben.

Das Senden der ersten und zweiten Signale über die Ausgänge und das Überwachen des ersten und zweiten Eingangs erfolgt insbesondere mittels einer Verarbeitungseinheit der Meldegerätauswertevorrichtung. Vorzugsweisewird bei dem Überwachen der Eingänge kontrolliert, ob ein Signal am ersten und zweiten Eingang anliegt und sofern ein Signal anliegt, wie dieses ausgebildet ist. Hierbei wird insbesondere überprüft, ob das über den ersten Ausgang ausgegebene Signal mit dem am ersten Eingang empfangenen Signal übereinstimmt oder durch das Meldegerät charakteristisch geändert wurde und ob das über den zweiten Ausgang ausgegebene Signal mit dem am zweiten Eingang empfangenen Signal übereinstimmt oder durch das Meldegerät charakteristisch geändert wurde. Bei einem charakteristischen Ändern der dynamischen Signale durch das Meldegerät ist in der Meldegerätauswertevorrichtung hinterlegt, wie das durch das Meldegerät charakteristisch geänderte dynamische Signal ausgebildet ist.

In der Meldegerätauswertevorrichtung ist vorzugsweise hinterlegt, in welchem Schaltzustand des Meldegerätes eine Änderung der dynamischen Signale durch das Meldegerät erfolgt, so dass ein Rückschluss auf den vorliegenden Schaltzustand des Meldegerätes gewonnen werden kann.

Wird am ersten Eingang das am ersten Ausgang ausgegebene erste Signal unverfälscht empfangen, so fand keine Änderung des ersten Signals durch das Meldegerät statt. Wird am zweiten Eingang das am zweiten Ausgang ausgegebene zweite Signal unverfälscht empfangen, so fand keine Änderung des zweiten Signals durch das Meldegerät statt.

Bei dem Ändern des Signals kann beispielsweise bei dem empfangenen dynamischen Signal eine vorliegende Taktrate durch das Meldegerät geändert werden. Es ist ebenso denkbar, dass bei dem Ändern des Signals die Weiterleitung des empfangenen dynamischen Signals durch das Meldegerät vollständig unterbunden wird.

Ermittelt das Meldegerät mittels des ersten und zweiten Sensors, dass der erste Stößel nicht die erste Position aufweist und der zweite Stößel nicht die zweite Position aufweist, so leitet das Meldegerät das über das Meldegerät geführte erste und zweite dynamische Signal unverändert weiter.

Wird ein dynamisches Signal über die Ausgänge gesandt und an beiden Eingängen liegt jeweils das durch das Meldegerät geänderte Signal an, so kann die Meldegerätauswertevorrichtung hieraus den vorliegenden Schaltzustand des Meldegerätes ermitteln. Nehmen beispielsweise die Stößel bei einer Betätigung des Meldegerätes (z.B. ein Drucktaster, ein Drehschalter, ein Schlüsselschalter oder ein Not-Aus Schalter) jeweils die erste Position ein, so werden durch eine Betätigung des Betätigers die dynamischen Signale durch das Meldegerät geändert. Die Meldegerätauswertevorrichtung überwacht die an ihren Eingängen anliegenden Signale und erkennt nach einer Betätigung des Betätigers des Meldegerätes, dass das über die Ausgänge ausgegebene Signal geändert wurde. Die Meldegerätauswertevorrichtung erkennt hierüber, dass das Meldegerät betätigt wurde und somit eine Zustandsänderung durchgeführt hat. Die Meldegerätauswertevorrichtung gibt vorzugsweise hierauf ein Signal aus, welches beispielsweise zum Abschalten einer sicherheitskritischen Applikation führt. Durch die redundante Auswertung der beiden dynamischen Signale erfolgt eine sichere Auswertung des Schaltzustandes des Meldegerätes durch die Meldegerätauswertevorrichtung.

Zusätzlich zur Ermittlung des Schaltzustandes des Meldegerätes werden durch die Meldegerätauswertevorrichtung vorzugsweise ferner Fehler hinsichtlich der Anbindung des Meldegerätes mit der Meldegeräteauswertevorrichtung oder hinsichtlich der ordnungsgemäßen Funktion des Meldegerätes ermittelt. Ergibt die Überprüfung der Eingänge, dass lediglich über einen der Eingänge das über den zugehörigen Ausgang ausgegebene dynamische Signal empfangen wird, so liegt ein Fehler vor. Die Meldegerätauswertevorrichtung gibt hierauf vorzugsweise ein Fehlersignal aus. Dieses Fehlersignal führt beispielsweise zum Abschalten einer sicherheitskritischen Applikation.

In einer vorteilhaften Ausführungsform der Erfindung ist das dynamische Signal ein getaktetes Signal.

Vorzugsweise weist das erste dynamische Signal eine Frequenz im Bereich von ca. 10 Hz bis 1 MHz und einen definierten Spannungspegel im Bereich von ca. 5 Volt bis 24 Volt auf. Das zweite dynamische Signal ist ein Signal im gleichen Frequenzbereich und Spannungsbereich wie das erste Signal. Das zweite dynamische Signal ist vorzugsweise invertiert zum ersten dynamischen Signal.

Es ist denkbar, dass das erste dynamische Signal ein digital oder analog übertragendes Codewort oder eine digital oder analog übertragende Codewort-Folge mit einer definierten Länge (zum Beispiel 1 Byte) ist. Das zweite dynamische Signal wird physikalisch identisch zum ersten Signal übertagen und unterscheidet sich im Codewort oder der Codewort-Folge. Das zweite Signal ist zum Beispiel invertiert zum ersten dynamischen Signal.

Zur Überprüfung des vorliegenden Schaltzustandes des Meldegerätes wird durch die Sicherheitsauswerteeinheit vorzugsweise beständig ein dynamisches Signal ausgegeben. Das dynamische Signal ist vorzugsweise derart ausgebildet, dass mindestens alle 100 Mikrosekunden ein Spannungsimpuls über den jeweiligen Ausgang gesandt wird.

In einer weiteren vorteilhaften Ausführungsform der Erfindung kann die Meldegerätauswertevorrichtung durch das Ausgeben der dynamischen Signale über ihre Ausgänge und dem Überwachen ihrer Eingänge kritische Zustände hinsichtlich des Systems ermittel. Ein kritischer Zustand liegt insbesondere vor, wenn der erste und/oder zweite Stößel die erste Position aufweist. Ermittelt die Meldegerätauswertevorrichtung einen kritischen Zustand, so wird mittels der Meldegerätauswertevorrichtung vorzugsweise eine sicherheitskritische Applikation abgeschaltet.

In einer weiteren vorteilhaften Ausführungsform der Erfindung umfasst das Meldegerät einen Betätiger, wobei durch eine Betätigung des Betätigers der erste und zweite Stößel jeweils seine erste Position einnimmt. Durch eine Betätigung des Betätigers ändert sich der Schaltzustand des Meldegerätes. Das Meldegerät kann vorzugsweise lediglich zwei Schaltstellungen einnehmen, welche durch den Betätiger herbeiführbar sind.

Wird der Betätiger betätigt, so nimmt hierdurch der erste und zweite Stößel jeweils seine erste Position ein, d.h. der erste und zweite Stößel weist vor seiner Betätigung nicht die erste Position auf.

In Abhängigkeit der Anordnung des ersten Stößels gegenüber dem ersten Sensor kann die erste Position des ersten Stößels vorliegen, wenn der erste Sensor den ersten Stößel detektiert oder wenn der erste Sensor den ersten Stößel nicht mehr detektiert. In Abhängigkeit der Anordnung des zweiten Stößels gegenüber dem zweiten Sensor kann die erste Position des zweiten Stößels vorliegen, wenn der zweite Sensor den zweiten Stößel detektiert oder wenn der zweite Sensor den zweiten Stößel nicht mehr detektiert.

Der Betätiger ist beispielsweise ein zu betätigendes Schaltelement eines Not-Aus Schalters.

In einer weiteren vorteilhaften Ausführungsform der Erfindung umfasst die Meldegerätauswertevorrichtung eine erste und eine zweite Verarbeitungseinheit. Die erste Verarbeitungseinheit kann das erste dynamische Signal über den ersten Ausgang senden und/oder ein am ersten Eingang anliegendes Signal auswerten. Bei dem Auswerten des am ersten Eingang anliegenden Signals wird durch die erste Verarbeitungseinheit überprüft, ob es sich bei dem über den ersten Eingang empfangen Signal um das über den ersten Ausgang ausgegebenen dynamischen Signal handelt.

Die zweite Verarbeitungseinheit kann das zweite dynamische Signal über den zweiten Ausgang senden und/oder ein am zweiten Eingang anliegendes Signal auswerten. Bei dem Auswerten des am zweiten Eingang anliegenden Signals wird durch die zweite Verarbeitungseinheit überprüft, ob es sich bei dem über den zweiten Eingang empfangen Signal um das über den zweiten Ausgang ausgegebenen dynamischen Signal handelt.

Die Meldegerätauswertevorrichtung umfasst hierfür beispielswiese zwei voneinander getrennt ausgebildete Verarbeitungseinheiten, mittels welchen das Senden und/oder Auswerten der Signale erfolgt.

In einer weiteren vorteilhaften Ausführungsform der Erfindung ist das Meldegerät modular aufgebaut und umfasst ein Basiserfassungsmodul und ein erstes Erweiterungserfassungsmodul, wobei das Basiserfassungsmodul den ersten und zweiten Sensor umfasst und im ersten Erweiterungserfassungsmodul der zweiten Stößel beweglich gelagert ist. Das erste Erweiterungserfassungsmodul umfasst somit den zweiten Stößel.

Vorzugsweise ist im Basiserfassungsmodul der erste Stößel beweglich gelagert. Es ist jedoch ebenso denkbar, dass das Meldegerät ein zweites Erweiterungserfassungsmodul umfasst, in welchem der erste Stößel beweglich gelagert ist. Das zweite Erweiterungserfassungsmodul ist vorzugsweise baugleich zum ersten Erweiterungserfassungsmodul ausgebildet.

In einer weiteren vorteilhaften Ausführungsform der Erfindung umfasst das Meldegerät ein Aufnahmemodul, wobei das Basiserfassungsmodul und das erste Erweiterungserfassungsmodul mechanisch über die selbe erste Seitenfläche des Aufnahmemoduls mit dem Aufnahmemodul verbunden sind und der Betätiger mechanisch mit der der ersten Seitenfläche gegenüberliegenden zweiten Seitenfläche des Aufnahmemoduls verbunden ist. Im zusammengebauten Zustand des Meldegerätes sind der Betätiger sowie das Basiserfassungsmodul und das erste Erweiterungserfassungsmodul mechanisch zerstörungsfrei lösbar mit dem Aufnahmemodul verbunden. Vorzugsweise kann das Aufnahmemodul ferner ein zweites Erweiterungserfassungsmodul mechanisch zerstörungsfrei lösbar aufnehmen. Die Verbindung der einzelnen Module mit dem Aufnahmemodul erfolgt vorzugsweise jeweils mittels einer Schnappverbindung.

Das Aufnahmemodul ist insbesondere derart ausgebildet, dass es unterschiedliche Betätiger aufnehmen kann. Der Betätiger ist die Baueinheit des Meldegerätes, über welche ein Anwender eine Zustandsänderung des Meldegerätes herbeiführen kann. Der Betätiger umfasst hierfür beispielsweise ein Tastelement oder ein Schaltelement. Mittels des Tastelements wird für den Zeitraum seiner Betätigung eine Zustandsänderung am Meldegerät herbeigeführt. Bei dem Schaltelement kann durch eine Auswahl der Schaltstellungen des Schaltelements der Zustand des Meldegerätes bestimmt werden.

Durch eine Betätigung des Betätigers werden der erste und der zweite Stößel des Meldegerätes in ihre erste Position ausgelenkt. Hierdurch kann sichergestellt werden, dass bei einem Defekt eines Stößels dennoch bei einer Betätigung des Betätigers eine Zustandsänderung am Meldegerät herbeigeführt wird.

Der erste Stößel des Meldegerätes ist im Meldegerät, insbesondere im Basiserfassungsmodul oder im zweiten Erweiterungserfassungsmodul des Meldegerätes, beweglich gelagert. Vorzugsweise wird auf den ersten und zweiten Stößel des Meldegerätes jeweils eine Kraft, insbesondere Federkraft, ausgeübt, welche den Stößel im ungekoppelten Zustand seines Moduls mit dem Aufnahmemodul in eine Grundposition bewegt, welche nicht der ersten Position des Stößels entspricht. Die erste Position liegt vor, wenn das jeweilige Modul (Basiserfassungsmodul, erstes oder zweite Erweiterungserfassungsmodul) ordnungsgemäß mit dem Aufnahmemodul, welches mit einem Betätiger verbunden ist, verbunden ist und wenn zusätzlich der Betätiger betätigt wurde, d.h. das Tastelement wurde betätigt bzw. eine definierte Schaltstellung des Schaltelements liegt vor.

Mittels des ersten Sensors kann gezielt der Zustand des ersten Stößels erfasst werden, in welchem sich der erste Stößel in seiner ersten Position befindet. Mittels des zweiten Sensors kann gezielt der Zustand des zweiten Stößels erfasst werden, in welchem sich der zweite Stößel in seiner ersten Position befindet.

Die Erfassung der ersten Position des ersten Stößels mittels des ersten Sensors und die Erfassung der ersten Position des zweiten Stößels mittels des zweiten Sensors erfolgt vorzugsweise auf induktive, kapazitive, optische oder magnetische Weise.

Der erste und zweite Sensor ist vorzugsweise auf einer Leiterplatte des Basiserfassungsmoduls angeordnet. Vorzugsweise wird bei der Auslenkung des ersten und zweiten Stößels der erste und/oder zweite Stößel im Wesentlichen parallel zu der Leiterplatte bewegt.

Sofern der erste Stößel im Basiserfassungsmodul beweglich gelagert ist, so ragt vorzugsweise der erste Stößel im ungekoppelten Zustand des Basiserfassungsmoduls mit dem Aufnahmemodul aus dem Basiserfassungsmoduls heraus und befindet sich in der Grundposition. Durch das mechanische Verbinden des Basiserfassungsmoduls mit dem Aufnahmemodul wird der erste Stößel in eine zweite Position ausgelenkt. Durch eine Betätigung des Betätigers wird der erste Stößel aus der zweiten Position in die erste Position ausgelenkt. Dadurch, dass der erste Sensor gezielt den Zustand des ersten Stößels in seiner ersten Position detektiert, kann mittels des ersten Sensors gezielt eine Betätigung des Betätigers erfasst werden. Ist der erste Stö-ßel im zweiten Erweiterungsmodul beweglich gelagert, so erfolgt die Auslenkung des ersten Stößels im zweiten Erweiterungsmodul analog zur beschriebenen Auslenkung des ersten Stößels im Basiserfassungsmodul.

Dadurch, dass die erste Position des ersten Stößels des Meldegerätes berührungslos mittels des ersten Sensors erfasst wird, liegt eine äußerst verschleißarme Stößelüberwachung vor. Ferner wird eine flexible Stößelführung innerhalb des Meldegerätes ermöglicht. Es kann beispielsweise trotz zentraler Ermittlung der Position des ersten Stößels innerhalb des Basiserfassungsmoduls der erste Stößel außerhalb des Basiserfassungsmoduls geführt werden, z.B. im zweiten Erweiterungserfassungsmodul. Hierdurch wird ein äußerst flexiblerer Aufbau des Meldegerätes ermöglicht.

Das erste Erweiterungserfassungsmodul ist insbesondere unmittelbar einer ersten Seitenfläche des Basiserfassungsmoduls gegenüberliegend angeordnet. Der zweite Stößel des ersten Erweiterungserfassungsmoduls ist im ersten Erweiterungserfassungsmodul beweglich gelagert. Mittels des zweiten Sensors des Basiserfassungsmoduls kann gezielt der Zustand des zweiten Stößels erfasst werden, in welchem sich der zweite Stößel in der ersten Position befindet.

Die Erfassung des Zustandes des Betätigers über die Position des ersten und zweiten Stößels erfolgt zentral durch das Basiserfassungsmodul.

Da das Basiserfassungsmodul und das Erweiterungserfassungsmodul lediglich mit dem Aufnahmemodul gekoppelt werden muss, werden eine einfache Montage und ein einfacher Aufbau erzielt.

In einer vorteilhaften Ausführungsform der Erfindung ragt der zweite Stößel im ungekoppelten Zustand des ersten Erweiterungserfassungsmoduls mit dem Aufnahmemodul aus dem ersten Erweiterungserfassungsmodul heraus und weist seine Grundposition auf.

Eine Auslenkung des zweiten Stößels in die erste Position wird durch das mechanische Verbinden des ersten Erweiterungserfassungsmoduls mit dem Aufnahmemodul, welches mit dem Betätigter mechanisch verbunden ist, und einer zusätzlichen Betätigung des Betätigers des Meldegerätes herbeigeführt. Der zweite Stößel wird hierbei insbesondere in das geräteinnere des ersten Erweiterungserfassungsmoduls bewegt. Das Basiserfassungsmodul kann mittels seines zweiten Sensors die Auslenkung des zweiten Stößels in die erste Position erfassen, so dass hierüber einen Rückschluss auf den Schaltzustand des Meldegerätes gewonnen werden kann.

In einer weiteren vorteilhaften Ausführungsform der Erfindung liegt die erste Position des ersten Stößels vor, wenn das erste Erweiterungserfassungsmodul ordnungsgemäß mit dem Aufnahmemodul des Meldegerätes, welches ordnungsgemäß mechanisch mit dem Betätiger des Meldegerätes verbunden ist, mechanisch verbunden ist und der Betätiger betätigt wurde.

Mittels des zweiten Sensors kann das Basiserfassungsmodul berührungslos detektieren, ob der zweite Stößel die erste Position aufweist oder nicht. Wird die erste Position des zweiten Sensors detektiert, so liegt ein ordnungsgemäß gekoppeltes erstes Erweiterungserfassungsmodul mit dem Aufnahmemodul vor, bei welchem der Betätiger betätigt wurde.

In einer weiteren vorteilhaften Ausführungsform der Erfindung umfasst das Meldegerät ein dem Basiserfassungsmodul nebengeordnetes zweites Erweiterungserfassungsmodul, welches den ersten Stößel beweglich lagert, wobei das Basiserfassungsmodul mit dem ersten Sensor berührungslos die erste Position des ersten Stößels erfassen kann. Das zweite Erweiterungserfassungsmodul ist separat zum Basiserfassungsmodul ausgebildet und ist insbesondere baugleich zum ersten Erweiterungserfassungsmodul ausgebildet.

Das erste Erweiterungserfassungsmodul liegt vorzugsweise unmittelbar einer ersten Seitenfläche des Basiserfassungsmoduls gegenüber. Das zweite Erweiterungserfassungsmodul liegt insbesondere unmittelbar einer zweiten Seitenfläche des Basiserfassungsmoduls, welche der ersten Seitenfläche des Basiserfassungsmoduls gegenüberliegt, gegenüber.

In einer weiteren vorteilhaften Ausführungsform der Erfindung ist der erste Sensor ein erster Hallsensor, welcher einen ersten Magneten des ersten Stößels detektieren kann, und der zweite Sensor ist ein zweiter Hallsensor, welcher einen zweiten Magneten des zweiten Stößels detektieren kann.

Der Magnet des jeweiligen Stößels ist insbesondere im Inneren des Basiserfassungsmoduls bzw. Erweiterungserfassungsmoduls angeordnet, insbesondere am Ende des Stößels.

Die erste Stößelposition des ersten Stößels kann vorliegen, wenn der erste Sensor den Magneten des ersten Stößels detektiert oder wenn durch den ersten Sensor der Magneten des ersten Stößels nicht mehr detektiert wird. Die erste Stößelposition des zweiten Stößels kann vorliegen, wenn der zweite Sensor den Magneten des zweiten Stößels detektiert oder wenn durch den zweiten Sensor der Magneten des zweiten Stößels nicht mehr detektiert wird.

Die Hallsensoren sind vorzugsweise auf der Leiterplatte des Basiserfassungsmoduls derart angeordnet, dass:
- der erste Sensor lediglich den ersten Magneten des ersten Stößels in der ersten Stößelposition detektieren kann,
- der zweite Sensor lediglich den ersten Magneten des zweiten Stößels in der ersten Stößelposition detektieren kann.

In einer vorteilhaften Ausführungsform der Erfindung umfasst die Meldegerätauswertevorrichtung ein Kommunikationsmittel, mittels welchem die Meldegerätauswertevorrichtung mit einem übergeordneten Bussystem kommunizieren kann. Das übergeordnete Bussystem ist beispielsweise ein PROFIBUS, PROFINET, AS-Interface oder IO-Link Kommunikationssystem. Über das Kommunikationsmittel kann die Meldegerätauswertevorrichtung den vorliegenden Schaltzustand des Meldegerätes an das übergeordnete Kommunikationssystem ausgeben.

In einer weiteren vorteilhaften Ausführungsform der Erfindung umfasst die Meldegerätauswertevorrichtung einen dritten Ausgang und kann über diesen dritten Ausgang ein Schaltgerät, insbesondere ein Schütz, schalten. Das Schaltgerät kann beispielsweise innerhalb einer sicherheitskritischen Applikation derart verbaut sein, dass die Meldegerätauswertevorrichtung über den dritten Ausgang bei einer Betätigung des Meldegerätes das Schaltgerät derart ansteuert, dass die sicherheitskritische Applikation abgeschaltet wird.

In einer weiteren vorteilhaften Ausführungsform der Erfindung umfasst das Basiserfassungsmodul eine Lichtquelle (z.B. eine LED), über welche eine Ausleuchtung des Betätigers des Meldegeräts erfolgt. Liegt ein transparenter Betätiger vor, so liegt im aktiven Betrieb der Lichtquelle ein leuchtender Betätiger vor.

In einer weiteren vorteilhaften Ausführungsform der Erfindung sind das Basiserfassungsmodul und das erste und zweite Erweiterungserfassungsmodul mechanisch mit einem Aufnahmemodul des Meldegerätes verbunden, wobei das zweite Erweiterungserfassungsmodul baugleich zum ersten Erweiterungserfassungsmodul ausgebildet ist, wobei das zweite Erweiterungserfassungsmodul gegenüber dem ersten Erweiterungserfassungsmodul um 180° gedreht mit dem Aufnahmemodul mechanisch verbunden ist. Das erste und zweite Erweiterungserfassungsmodul stellt über die gleiche Seitenfläche der Erweiterungserfassungsmodule die mechanische Verbindung zum Aufnahmemodul her. Im gedrehten Zustand des zweiten Erweiterungserfassungsmoduls sind insbesondere die Stößel der ersten und zweiten Erweiterungserfassungsmodule zueinander versetzt angeordnet.

Durch die zentrale Erfassung der Position der Stößel durch das Basiserfassungsmodul muss lediglich das Basiserfassungsmodul eine Leiterplatte mit den Sensoren umfassen. Die ansonsten notwendigen Leiterplatten für die Erweiterungserfassungsmodule können entfallen. Ferner kann eine zentrale Anbindung des Meldegerätes an die Meldegerätauswertevorrichtung über das Basiserfassungsmodul erfolgen. Hierdurch werden Kosten eingespart und ferner kann die Baugröße des Meldegerätes verringert werden.

Durch die zentrale Erfassung der Stößelposition sowie der Ausgabe des Schaltzustandes des Meldegerätes durch die Auswerteeinheit im Basiserfassungsmodul wird für den Anwender eine verbesserte, übersichtliche Installation sowie Konfiguration eines Meldegerätes erzielt.

Durch die redundante Überwachung des vorliegenden Schaltzustandes des Meldegerätes mittels der dynamischen Signale und der redundanten Ermittlung des vorliegenden Schaltzustandes am Meldegerät mittels der beiden Stößel kann eine sichere Meldegerätauswertevorrichtung bereitgestellt werden.

Im Folgenden werden die Erfindung und Ausgestaltungen der Erfindung anhand der in den Figuren dargestellten Ausführungsbeispiele näher beschrieben und erläutert. Es zeigen:
- FIG 1: eine schematische Darstellung eines Systems mit einem Meldegerät und einer dezentral zum Meldegerät angeordneten Meldegerätauswertevorrichtung, und
- FIG 2: eine schematische Darstellung des Systems aus Figur 1, wobei die Stößel des Meldegerätes die erste Position aufweisen.

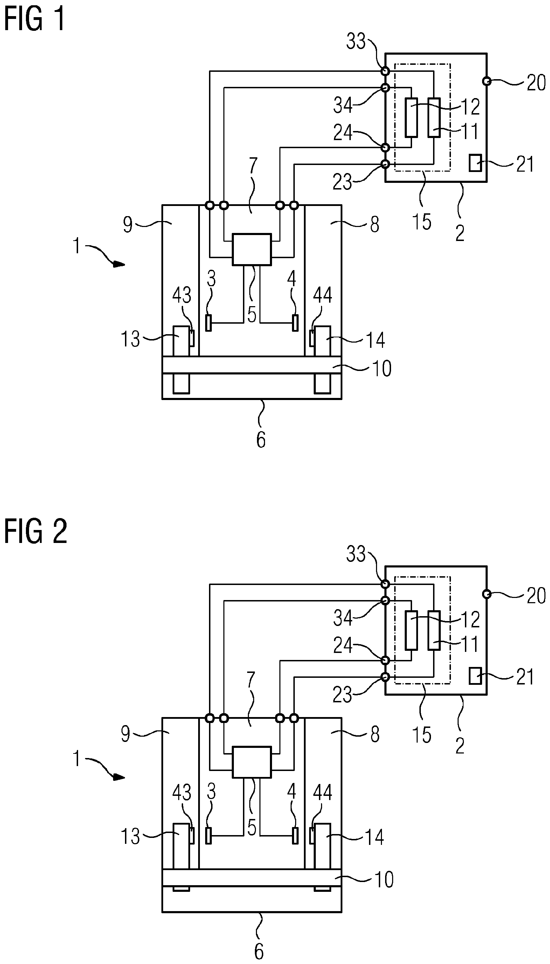

FIG 1 zeigt eine schematische Darstellung eines Systems mit einem Meldegerät 1 und einer dezentral zum Meldegerät 1 angeordneten Meldegerätauswertevorrichtung 2. Das Meldegerät 1 ist modular aufgebaut und umfasst ein Basiserfassungsmodul 7, ein erstes Erweiterungserfassungsmodul 8, ein zweites Erweiterungserfassungsmodul 9, ein Aufnahmemodul 10 und einen Betätiger 6. Das Meldegerät 1 ist in ein Not-Aus Schalter.

Das Basiserfassungsmodul 7 und das erste und zweite Erweiterungserfassungsmodul 8,9 sind mechanisch über eine erste Seitenfläche des Aufnahmemoduls 10 mit dem Aufnahmemodul 10 verbunden. Der Betätiger 6 ist mechanisch mit einer der ersten Seitenfläche gegenüberliegenden zweiten Seitenfläche des Aufnahmemoduls 10 verbunden.

Das Basiserfassungsmodul 7 umfasst eine Leiterplatte auf welcher ein erster Sensor 3, ein zweiter Sensor 4 und eine Auswerteeinheit 5 angeordnet sind.

Das erste Erweiterungserfassungsmodul 8 umfasst einen zweiten Stößel 14. Der zweite Stößel 14 ist im ersten Erweiterungserfassungsmodul 8 beweglich gelagert und umfasst einen ersten Magneten 44, welcher im Inneren des ersten Erweiterungserfassungsmoduls 8 angeordnet ist.

Das zweite Erweiterungserfassungsmodul 9 umfasst einen ersten Stößel 13. Der erste Stößel 13 ist im zweiten Erweiterungserfassungsmodul 9 beweglich gelagert und umfasst einen zweiten Magneten 43, welcher im Inneren des zweiten Erweiterungserfassungsmoduls 9 angeordnet ist.

Der Betätiger 6 umfasst das Schaltelement des Not-Aus-Schalters. In der Figur 1 ist der Notausschalter in seiner Grundposition und wurde nicht betätigt. Durch eine Betätigung des Betätigers 6 wird der erste und zweite Stößel 13,14 jeweils in seine erste Position bewegt; d.h. in der abgebildeten Grundposition des Betätigers 6 weist der erste und zweite Stößel 13,14 nicht seine erste Position auf.

Das Meldegerät 1 kann zwei Schaltzustände einnehmen. Ist der Betätiger 6 in der Grundposition so liegt am Meldegerät 1 der erste Schaltzustand vor. Wurde der Betätiger 6 betätigt, so dass die Stößel 13,14 die erste Position aufweisen, so liegt am Meldegerät 1 ein zweiter Schaltzustand vor.

Der erste Sensor 3 ist ein erster Hallsensor. Der zweite Sensor 4 ist ein zweiter Hallsensor.

Der erste Sensor 3 sowie der erste Magnet 43 des ersten Stößels 13 sind derart zueinander angeordnet, dass der erste Sensor 3 den ersten Magneten 43 lediglich in der ersten Position des ersten Stößels 13 detektiert; d.h. in der abgebildeten Position des ersten Stößels 13 detektiert der erste Sensor 3 nicht den ersten Magneten 43.

Der zweite Sensor 4 sowie der zweite Magnet 44 des zweiten Stößels 14 sind derart zueinander angeordnet, dass der zweite Sensor 4 den zweiten Magneten 44 lediglich in der ersten Position des zweiten Stößels 14 detektiert; d.h. in der abgebildeten Position des zweiten Stößel 14 detektiert der zweite Sensor 4 nicht den zweiten Magneten 44.

Der erste Sensor 3 kann berührungslos über den ersten Magneten 43 die erste Position des ersten Stößels 13 erfassen und der zweite Sensor 4 kann berührungslos über den zweiten Magneten 44 die erste Position des zweiten Stößels 14 erfassen.

Die Meldegerätauswertevorrichtung 2 umfasst einen ersten Ausgang 23, einen zweiten Ausgang 24, einen dritten Ausgang 20, eine Kommunikationsmittel 21, eine erste Verarbeitungseinheit 11, eine zweite Verarbeitungseinheit 12, einen ersten Eingang 33 und einen zweiten Eingang 34.

Die Meldegerätauswertevorrichtung 2 sendet zum sicheren Erfassen des Schaltzustandes des Meldegerätes 1 über den ersten Ausgang 23 ein erstes dynamisches Signal und über den zweiten Ausgang 24 ein zweites dynamisches Signal, welches unterschiedlich zum ersten dynamischen Signal ist.

Die Meldegerätauswertevorrichtung 2 ist mit dem Meldegerät 1 derart verbunden, dass das über den ersten Ausgang 23 ausgegebene erste dynamisches Signal über das Meldegerät 1, insbesondere über die Auswerteeinheit 5, zum ersten Eingang 33 geführt werden kann und das über den zweiten Ausgang 24 ausgegebenes zweites dynamisches Signal über das Meldegerät 1, insbesondere über die Auswerteeinheit 5, zum zweiten Eingang 34 geführt werden kann.

Das erste und zweite dynamische Signal ist jeweils ein getaktetes Signal.

Die Auswerteeinheit 5 des Meldegerätes 1 ist derart ausgebildet, dass sie ein über das Meldegerät 1 geführtes erstes dynamisches Signal ändert, wenn die erste Position des ersten Stößels 13 durch das Meldegerät 1 mittels des ersten Sensors 3 ermittelt wird, und ein über das Meldegerät 1 geführtes zweites dynamisches Signal ändert, wenn die erste Position des zweiten Stößels 14 durch das Meldegerät 1 mittels des zweiten Sensors 4 ermittelt wird. Sofern der jeweilige Stößel 13,14 nicht die erste Position aufweist, so wird das empfangene dynamische Signal unverändert an die Meldegerätauswertevorrichtung 2 weitergeleitet, so dass am ersten Eingang 33 das über den ersten Ausgang 23 ausgegebene Signal unverändert anliegt und am zweiten Eingang 34 das über den zweiten Ausgang 24 ausgegebene Signal unverändert anliegt.

Die Meldegerätauswertevorrichtung 2 überwacht mittels der Verarbeitungseinheit 15, welche die erste zweite Verarbeitungseinheit 11,12 umfasst, den ersten und zweiten Eingang 33,34 und ermittelt hieraus den vorliegenden Schaltzustand des Meldegerätes 1.

Das Senden des ersten dynamischen Signals über den ersten Ausgang 23 und das Auswerten des am ersten Eingang 33 anliegenden Signals erfolgt mittels der ersten Verarbeitungseinheit 11. Das Senden des zweiten dynamischen Signals über den zweiten Ausgang 24 und das Auswerten des am zweiten Eingang 34 anliegenden Signals erfolgt mittels der zweiten Verarbeitungseinheit 12. Die erste Verarbeitungseinheit 11 ist separat zur zweiten Verarbeitungseinheit 12 ausgebildet. Hierdurch wird Fehlersicherheit des Systems verbessert.

Ergibt die Überwachung des ersten und zweiten Eingangs 33,34, dass das über den zugeordneten Ausgang 23,24 ausgegeben dynamische Signal unverändert empfangen wird, so erkennt die Meldegerätauswertevorrichtung 2, dass der erste Schaltzustand am Meldegerät 1 vorliegt.

Ergibt die Überwachung des ersten und zweiten Eingangs 33,34, dass das über den zugeordneten Ausgang 23,24 ausgegeben dynamische Signal charakteristisch durch das Meldegerät 1 verändert empfangen wird, so erkennt die Meldegerätauswertevorrichtung 2, dass der zweite Schaltzustand am Meldegerät 1 vorliegt. In der Meldegerätauswertevorrichtung 2 ist hinterlegt, wie das jeweilige charakteristische Ändern der beiden ausgegeben dynamischen Signale durch das Meldegerät 1 erfolgt, so dass die Meldegerätauswertevorrichtung 2 den zweiten Schaltzustand, in welcher die Stößel 13,14 die erste Position aufweisen, erkennt.

Die Meldegerätauswertevorrichtung 2 umfasst die Kommunikationseinheit 21. Über die Kommunikationseinheit ist die Meldegerätauswertevorrichtung 2 mit einem AS-i System verbunden. Die Meldegerätauswertevorrichtung 2 kann als AS-i Slave dem AS-i Master des AS-i Systems den vorliegenden Schaltzustand des Meldegerätes 1 übermitteln. Wird der zweite Schaltzustand durch die Meldegerätauswertevorrichtung 2 ermittelt, so sendet die Meldegerätauswertevorrichtung 2 dem AS-i Master ein entsprechendes Telegramm, welches die Zustandsänderung des Meldegerätes 1 anzeigt. Das AS-i System umfasst einen AS-i Sicherheitsmonitor. Der AS-i Sicherheitsmonitor überwacht die Kommunikation zwischen dem AS-i Master und der Meldegerätauswertevorrichtung 2. Der AS-i Sicherheitsmonitor kann das von der Meldegeräteauswertevorrichtung 2 gesendete Telegramm erfassen und daraufhin z.B. den sicheren Zustand einer Gefahr verursachenden Anlage herbeiführen.

Über den dritten Ausgang 20 der Meldegerätauswertevorrichtung 2 kann die Meldegerätauswertevorrichtung 2 ein den Schaltzustand des Meldegerätes 1 charakterisierendes Signal an ein Schaltgerät ausgeben. Die Ansteuerung des Schaltgerätes kann beispielsweise über den dritten Ausgang 20 erfolgen, so dass in Abhängigkeit des vorliegenden Schaltzustandes des Meldegerätes 1 die Meldegerätauswertevorrichtung 2 die Schaltstellung des Schaltgerätes, z.B. ein Schütz, bestimmt.

Bei dem in FIG 1 gezeigten Schaltzustand des Meldegerätes 1 empfängt die Meldegerätauswertevorrichtung 2 das beständig über den ersten Ausgang 23 gesendete erste dynamische Signal unverändert am ersten Eingang 33 und das beständig über den zweiten Ausgang 24 gesendete zweite dynamische Signal unverändert am zweiten Eingang 34. Die Meldegerätauswertevorrichtung 2 erkennt hieraus, dass das Meldegerät 1 die erste Schaltstellung aufweist.

FIG 2 zeigt eine schematische Darstellung des Systems aus FIG 1, wobei die Stößel 13,14 des Meldegerätes 1 die erste Position aufweisen. Im Unterscheid zur FIG 1 wurde in der FIG 2 der Betätiger 6 betätigt. Durch das Betätigen des Betätigers 6 wurden die Stößel 13,14 in ihre erste Position bewegt. Die Auswerteeinheit 5 ermittelt über den ersten Hallsensor 3, welcher berührungslos das charakteristische Magnetfeld des ersten Magneten 43 erfasst, dass der erste Stößel 13 die erste Stößelposition aufweist. Ferner ermittelt die Auswerteeinheit 5 über den zweiten Hallsensor 4, welcher berührungslos das charakteristische Magnetfeld des zweiten Magneten 44 erfasst, dass der zweite Stößel 14 die erste Stößelposition aufweist.

Die Auswerteeinheit 5 ändert aufgrund der Ermittlung, dass der erste Stößel 13 die erste Position aufweist, das über das Meldegerät 1 geführte erste dynamische Signal der Meldegerätauswertevorrichtung 2, und aufgrund der Ermittlung, dass der zweite Stößel 14 die erste Position aufweist, das über das Meldegerät 1 geführte zweite dynamische Signal der Meldegerätauswertevorrichtung 2. Das Ändern des ersten und zweiten Signals erfolgt in einer für die Meldegerätauswertevorrichtung 2 erkennbaren Weise. Bei dem Ändern der dynamischen Signale wird beispielsweise durch die Auswerteeinheit 5 jeweils die Taktrate des von der Meldegerätauswertevorrichtung 2 ausgegebenen dynamischen Signals verringert.

Die Verarbeitungseinheit 15 der Meldegerätauswertevorrichtung 2 überwacht den ersten und zweiten Eingang 33,34 und wertet die an den ersten und zweiten Eingängen 33,34 anliegenden Signale aus. Die erste Verarbeitungseinheit 11 erkennt, dass das über den ersten Ausgang 23 ausgegebene Signal durch das Meldegerät 1 geändert wurde. Die zweite Verarbeitungseinheit 12 erkennt, dass das über den ersten Ausgang 23 ausgegebene Signal durch das Meldegerät 1 geändert wurde. Die Meldegerätauswertevorrichtung 2 leitet hieraus ab, dass eine Zustandsänderung am Meldegerät 1 erfolgte und das Meldegerät 1 nun den zweiten Schaltzustand aufweist. Die Meldegerätauswertevorrichtung 2 gibt hierauf über das Kommunikationsmittel 21 ein Telegramm aus, welches den vorliegenden Schaltzustand des Meldegerätes 1 charakterisiert.

## Patentansprüche

1. System mit einem Meldegerät (1) und einer dezentral zum Meldegerät (1) angeordneten Meldegerätauswertevorrichtung (2), wobei das Meldegerät (1) einen ersten und zweiten Sensor (3,4), einen ersten und zweiten beweglich gelagerten Stößel (13,14) und eine Auswerteeinheit (5) umfasst, wobei der erste Sensor (3) berührungslos eine erste Position des ersten Stößels (13) erfasst und der zweite Sensor (4) berührungslos eine erste Position des zweiten Stößels (14) erfasst, wobei die Meldegerätauswertevorrichtung (2) einen ersten und zweiten Ausgang (23,24) und einen ersten und zweiten Eingang (33,34) umfasst und zum sicheren Erfassen des Schaltzustandes des Meldegerätes (1) über den ersten Ausgang (23) ein erstes dynamisches Signal und über den zweiten Ausgang (24) ein zweites dynamisches Signal, welches unterschiedlich zum ersten dynamischen Signal ist, sendet, wobei die Meldegerätauswertevorrichtung (2) mit dem Meldegerät (1) derart verbunden ist, dass ein über den ersten Ausgang (23) ausgegebenes erstes dynamisches Signal über das Meldegerät (1) zum ersten Eingang (33) geführt werden kann und ein über den zweiten Ausgang (24) ausgegebenes zweites dynamisches Signal über das Meldegerät (1) zum zweiten Eingang (34) geführt werden kann, wobei die Auswerteeinheit (5) das über das Meldegerät (1) geführte erste dynamische Signal ändert, wenn die erste Position des ersten Stößels (13) ermittelt wird, und das über das Meldegerät (1) geführte zweite dynamische Signal ändert, wenn die erste Position des zweiten Stößels (14) ermittelt wird, wobei die Meldegerätauswertevorrichtung (2) derart ausgebildet ist, dass sie den ersten und zweiten Eingang (33,34) überwacht und hieraus den Schaltzustand des Meldegerätes (1) ermittelt.

2. System nach Anspruch 1, wobei das Meldegerät (1) einen Betätiger (6) umfasst, wobei durch eine Betätigung des Betätigers (6) der erste und zweite Stößel (13,14) jeweils seine erste Position einnimmt.

3. System nach einem der vorhergehenden Ansprüche, wobei der erste Sensor (3) ein erster Hallsensor ist, welcher einen ersten Magneten (43) des ersten Stößels (13) detektieren kann, und der zweite Sensor (4) ein zweiter Hallsensor ist, welcher einen zweiten Magneten (44) des zweiten Stößels (14) detektieren kann.

4. System nach einem der vorhergehenden Ansprüche, wobei die Meldegerätauswertevorrichtung (2) eine erste und eine zweite Verarbeitungseinheit (11,12) umfasst, wobei die erste Verarbeitungseinheit (11) das erste dynamische Signal senden kann und/oder ein am ersten Eingang (33) anliegendes Signal auswerten kann, wobei die zweite Verarbeitungseinheit (12) das zweite dynamische Signal senden kann und/oder ein am zweiten Eingang (34) anliegendes Signal auswerten kann.

5. System nach einem der vorhergehenden Ansprüche, wobei das Meldegerät (1) modular aufgebaut ist und ein Basiserfassungsmodul (7) und ein erstes Erweiterungserfassungsmodul (8) umfasst, wobei das Basiserfassungsmodul (7) den ersten und zweiten Sensor (3,4) umfasst und im ersten Erweiterungserfassungsmodul (8) der zweiten Stößel (14) beweglich gelagert ist.

6. System nach Anspruch 2 und 5, wobei das Meldegerät (1) ein Aufnahmemodul (10) umfasst, wobei das Basiserfassungsmodul (7) und das erste Erweiterungserfassungsmodul (8) mechanisch über die selbe erste Seitenfläche des Aufnahmemoduls (10) mit dem Aufnahmemodul (10) verbunden sind und der Betätiger (6) mechanisch mit der der ersten Seitenfläche gegenüberliegenden zweiten Seitenfläche des Aufnahmemoduls (10) verbunden ist.

7. System nach einem der vorhergehenden Ansprüche, wobei das Meldegerät (1) ein zweites Erweiterungserfassungsmodul (9) umfasst, in welchem der erste Stößel (13) beweglich gelagert ist.

8. System nach einem der vorhergehenden Ansprüche, wobei das dynamische Signal ein getaktetes Signal ist.

9. System nach einem der vorhergehenden Ansprüche, wobei durch ein Ändern des ersten und zweiten dynamischen Signals durch die Auswerteeinheit (5) ein am Meldegerät (1) anliegendes erstes und zweites dynamisches Signal nicht an die Eingänge (33,34) der Meldegerätauswertevorrichtung (2) weitergeleitet wird.

10. System nach einem der vorhergehenden Ansprüche, wobei die Meldegerätauswertevorrichtung (2) ein Kommunikationsmittel (21) umfasst und über dieses Kommunikationsmittel (21) einen vorliegenden Schaltzustand des Meldegerätes (1) ausgeben kann.

11. Verfahren zum sicheren Ermitteln eines Schaltzustandes eines Meldegerätes (1) mit einem System nach einem der Ansprüche 1 bis 10, wobei die Meldegerätauswertevorrichtung (2) über den ersten Ausgang (23) ein erstes dynamisches Signal und über den zweiten Ausgang (24) ein zweites dynamisches Signal, welches unterschiedlich zum ersten dynamischen Signal ist, sendet, wobei das Meldegerät (1) über den ersten Sensor (3) die vorliegende Position des ersten Stößels (13) und über den zweiten Sensor (4) die vorliegende Position des zweiten Stößels (14) ermittelt und sofern der erste Stößel (13) die erste Position aufweist und der zweite Stößel (14) die zweite Position aufweist das über das Meldegerät (1) geführte erste und zweite dynamische Signal ändert, wobei die Meldegerätauswertevorrichtung (2) den ersten und zweiten Eingang (33,34) überwacht und hieraus den Schaltzustand des Meldegerätes (1) ermittelt.

12. Verfahren nach Anspruch 11, wobei das Meldegerät (1) einen Betätiger (6) umfasst, wobei der Betätiger (6) betätigt wird und hierdurch der erste und zweite Stößel (13,14) jeweils seine erste Position einnimmt.

## Claims

1. System with a signalling device (1) and a signalling device evaluation apparatus (2) arranged decentrally in respect of the signalling device (1), wherein the signalling device (1) comprises a first and second sensor (3, 4), a first and second moveably supported plunger (13, 14) and an evaluation unit (5), wherein the first sensor (3) acquires a first position of the first plunger (13) in a contactless manner and the second sensor (4) acquires a first position of the second plunger (14) in a contactless manner, wherein the signalling device evaluation apparatus (2) comprises a first and second output (23, 24) and a first and second input (33, 34) and for reliable acquisition of the switching state of the signalling device (1) sends a first dynamic signal by way of the first output (23) and a second dynamic signal by way of the second output (24), which second signal differs from the first dynamic signal, wherein the signalling device evaluation apparatus (2) is connected to the signalling device (1) such that a first dynamic signal output by way of the first output (23) can be guided by way of the signalling device (1) to the first input (33) and a second dynamic signal output by way of the second output (24) can be guided by way of the signalling device (1) to the second input (34), wherein the evaluation unit (5) changes the first dynamic signal guided by way of the signalling device (1) if the first position of the first plunger (13) is determined and changes the second dynamic signal guided by way of the signalling device (1) if the first position of the second plunger (13) is determined, wherein the signalling device evaluation apparatus (2) is embodied such that it monitors the first and second input (33, 34) and determines the switching state of the signalling device (1) therefrom.

2. System according to claim 1, wherein the signalling device (1) comprises an actuator (6), wherein by actuating the actuator (5) the first and second plunger (13, 14) each assumes its first position.

3. System according to one of the preceding claims, wherein the first sensor (3) is a first Hall sensor, which can detect a first magnet (43) of the first plunger (13) and the second sensor (4) is a second Hall sensor, which can detect a second magnet (44) of the second plunger (14).

4. System according to one of the preceding claims, wherein the signalling device evaluation apparatus (2) comprises a first and a second processing unit (11, 12), wherein the first processing unit (11) can send the first dynamic signal and/or can evaluate a signal present at the first input (33), wherein the second processing unit (12) can send the second dynamic signal and/or can evaluate a signal present at the second input (34).

5. System according to one of the preceding claims, wherein the signalling device (1) is of modular design and comprises a basic acquisition module (7) and a first expansion acquisition module (8), wherein the basic acquisition module (7) comprises the first and second sensor (3, 4) and is moveably supported in the first expansion acquisition module (8) of the second plunger (14).

6. System according to claim 2 and 5, wherein the signalling device (1) comprises a recording module (10), wherein the basic acquisition module (7) and the first expansion acquisition module (8) are mechanically connected to the recording module (10) by way of the same first lateral surface of the recording module (10) and the actuator (6) is mechanically connected to the second lateral surface of the recording module (10) which faces the first lateral surface.

7. System according to one of the preceding claims, wherein the signalling device (1) comprises a second expansion acquisition module (9), in which the first plunger (13) is moveably supported.

8. System according to one of the preceding claims, wherein the dynamic signal is a clocked signal.

9. System according to one of the preceding claims, wherein by changing the first and second dynamic signal by means of the evaluation unit (5), a first and second dynamic signal present at the signalling device (1) is not forwarded to the inputs (33, 34) of the signalling device evaluation apparatus (2) .

10. System according to one of the preceding claims, wherein the signalling device evaluation apparatus (2) comprises a communication means (21) and can output a current switching state of the signalling device (1) by way of this communication means (21).

11. Method for reliably determining a switching state of a signalling deice (1) with a system according to one of claims 1 to 10, wherein the signalling device evaluation apparatus (2) sends a first dynamic signal by way of the first output (23) and a second dynamic signal by way of the second output (24), which second signal differs from the first dynamic signal (3), wherein the signalling device (1) determines the current position of the first plunger (13) by way of the first second (3) and the current position of the second plunger (14) by way of the second sensor (4), and if the first plunger (13) has the first position and the second plunger (14) has the second position, changes the first and second dynamic signal guided by way of the signalling device (1), wherein the signalling device evaluation apparatus (2) monitors the first and second input (33, 34) and determines the switching state of the signalling device (1) herefrom.

12. Method according to claim 11, wherein the signalling device (1) comprises an actuator (6), wherein the actuator (6) is actuated and the first and second plunger (13, 14) each thereby assumes its first position.

## Revendications

1. Système comprenant un appareil ( 1 ) de signalisation et un dispositif ( 2 ) d'évaluation de l'appareil de signalisation, monté de manière décentrée par rapport à l'appareil ( 1 ) de signalisation, l'appareil ( 1 ) de signalisation comprenant un premier et un deuxième capteurs ( 3, 4 ), un premier et un deuxième poussoirs ( 13, 14 ) montés mobiles et une unité ( 5 ) d'évaluation, le premier capteur détectant sans contact une première position du premier poussoir ( 13 ) et le deuxième capteur ( 4 ) détectant sans contact une première position du deuxième poussoir ( 14 ), le dispositif ( 2 ) d'évaluation de l'appareil de signalisation comprenant une première et une deuxième sorties ( 23, 24 ) et une première et une deuxième entrées ( 33, 34 ) et envoyant, pour la détection sécurisée de l'état de commutation de l'appareil ( 1 ) de signalisation, par la première sortie ( 23 ), un premier signal dynamique, et par la deuxième sortie ( 24 ), un deuxième signal dynamique, qui est différent du premier signal dynamique, le dispositif ( 2 ) d'évaluation de l'appareil de signalisation étant relié à l'appareil ( 1 ) de signalisation, de manière à ce qu'un premier signal dynamique, émis par la première sortie ( 23 ), puisse être envoyé par l'appareil ( 1 ) de signalisation à la première entrée ( 33 ) et de manière à ce qu'un deuxième signal dynamique, émis par la deuxième sortie ( 24 ), puisse être envoyé par l'appareil ( 1 ) de signalisation à la deuxième entrée ( 34 ), l'unité ( 5 ) d'évaluation modifiant le premier signal dynamique envoyé par l'appareil ( 1 ) de signalisation, si la première position du premier poussoir ( 13 ) est déterminée, et modifiant le deuxième signal dynamique envoyé par l'appareil ( 1 ) de signalisation, si la première position du deuxième poussoir ( 14 ) est déterminée, le dispositif ( 2 ) d'évaluation de l'appareil de signalisation étant constitué de manière à contrôler la première et la deuxième entrée ( 33, 34 ) et à en déterminer l'état de commutation de l'appareil ( 1 ) de signalisation.

2. Système suivant la revendication 1, dans lequel l'appareil ( 1 ) de signalisation comprend un actionneur ( 6 ), le premier et le deuxième poussoirs ( 13, 14 ) prenant chacun sa première position par un actionnement de l'actionneur ( 6 ).

3. Système suivant l'une des revendications précédentes, dans lequel le premier capteur ( 3 ) est un premier capteur de Hall, qui peut détecter un premier aimant ( 43 ) du premier poussoir ( 13 ) et le deuxième capteur ( 4 ) est un deuxième capteur de Hall, qui peut détecter un deuxième aimant ( 44 ) du deuxième poussoir ( 14 ).

4. Système suivant l'une des revendications précédentes, dans lequel le dispositif ( 2 ) d'évaluation de l'appareil de signalisation comprend une première et une deuxième unités ( 11, 12 ) de traitement, la première unité ( 11 ) de traitement pouvant envoyer le premier signal dynamique et/ou évaluer un signal s'appliquant à la première entrée ( 33 ), la deuxième unité ( 12 ) de traitement pouvant envoyer le deuxième signal dynamique et/ou évaluer un signal s'appliquant à la deuxième entrée ( 34 ).

5. Système suivant l'une des revendications précédentes, dans lequel l'appareil ( 1 ) de signalisation est constitué de manière modulaire et comprend un module ( 7 ) de détection de base et un premier module ( 8 ) de détection d'extension, le module ( 7 ) de détection de base comprenant le premier et le deuxième capteurs ( 3, 4 ) et le deuxième poussoir ( 14 ) étant monté mobile dans le premier module ( 8 ) de détection d'extension.

6. Système suivant les revendications 2 et 5, dans lequel l'appareil ( 1 ) de signalisation comprend un module ( 10 ) de réception, le module ( 7 ) de détection de base et le premier module ( 8 ) de détection d'extension étant reliés mécaniquement par la même première surface latérale du module ( 10 ) de réception au module ( 10 ) de réception et l'actionneur ( 6 ) étant relié mécaniquement à la deuxième surface latérale du module ( 10 ) de réception opposée à la première surface latérale.

7. Système suivant l'une des revendications précédentes, dans lequel l'appareil ( 1 ) de signalisation comprend un deuxième module ( 9 ) de détection d'extension, dans lequel le premier poussoir ( 13 ) est monté mobile.

8. Système suivant l'une des revendications précédentes, dans lequel le signal dynamique est un signal cadencé.

9. Système suivant l'une des revendications précédentes, dans lequel, en modifiant le premier et le deuxième signal dynamique par l'unité ( 5 ) d'évaluation, un premier et un deuxième signal dynamique, s'appliquant à l'appareil ( 1 ) de signalisation, n'est pas acheminé aux entrées ( 33, 34 ) du dispositif ( 2 ) d'évaluation de l'appareil de signalisation.

10. Système suivant l'une des revendications précédentes, dans lequel le dispositif ( 2 ) d'évaluation de l'appareil de signalisation comprend un moyen ( 21 ) de communication et peut donner, par ce moyen ( 21 ) de communication, un état de commutation en cours de l'appareil ( 1 ) de signalisation.

11. Procédé de détermination sécurisée d'un état de commutation d'un appareil ( 1 ) de signalisation comprenant un système suivant l'une des revendications 1 à 10, dans lequel le dispositif ( 2 ) d'évaluation de l'appareil de signalisation envoie, par la première sortie ( 23 ), un premier signal dynamique et, par la deuxième sortie ( 24 ), un deuxième signal dynamique, qui est différent du premier signal dynamique, l'appareil ( 1 ) de signalisation déterminant, par le premier capteur ( 3 ), la position en cours du premier poussoir ( 13 ) et, par le deuxième capteur ( 4 ), la position en cours du deuxième poussoir ( 14 ) et, pour autant que le premier poussoir ( 13 ) a la première position et le deuxième poussoir ( 14 ) la deuxième position, modifie le premier et le deuxième signal dynamique envoyés par l'appareil ( 1 ) de signalisation, le dispositif ( 2 ) d'évaluation de l'appareil de signalisation contrôlant la première et la deuxième entrées ( 33, 34 ) et en déterminant l'état de commutation de l'appareil ( 1 ) de signalisation.

12. Procédé suivant la revendication 11, dans lequel l'appareil ( 1 ) de signalisation comprend un actionneur ( 6 ), l'actionneur ( 6 ) étant actionné et le premier et le deuxième poussoirs ( 13, 14 ) prenant ainsi chacun leur première position.
